# EUROPEAN PATENT SPECIFICATION

(11) **EP 0 637 776 B1**
(45) Date of publication and mention of the grant of the patent: **26.11.1997**
(21) Application number: 94907054.4
(22) Date of filing: 16.02.1994
(51) Int. Cl.: G03F 7/038, G03F 7/004

(54) **PHOTOSENSITIVE RESIN COMPOSITION AND PROCESS FOR FORMING RELIEF PATTERN THEREFROM**
Photoempfindliche Harzzusammensetzung und Verfahen zur Herstellung einesReliefmusters mit dieser Zusammensetzung
COMPOSITION DE RESINE PHOTOSENSIBLE ET PROCEDE DE FORMATION D'UNE CONFIGURATION EN RELIEF A PARTIR DE CETTE COMPOSITION

(30) Priority: 16.02.1993 JP 26400/93; 23.02.1993 JP 33202/93; 22.03.1993 JP 61544/93
(43) Date of publication of application: 08.02.1995
(73) Proprietor: SUMITOMO BAKELITE COMPANY LIMITED, Tokyo 100 (JP)
(72) Inventor: SASHIDA, Nobuyuki, Utsunomiya-shi Tochigi 321 (JP); BANBA, Toshio, Utsunomiya-shi Tochigi 321 (JP); TAKEDA, Naoshige, Utsunomiya-shi Tochigi 321 (JP); YAMAMOTO, Mitsuhiro, Hiroshima-shi Hiroshima 739-17 (JP)
(74) Representative: Vossius, Volker, Dr.
(86) International application number: JP9400231
(87) International publication number: WO9419725

(56) References cited:
- JP-A- 1 293 341
- JP-A- 4 120 542
- JP-A- 4 291 258
- JP-A-61 007 837
- JP-A-61 254 605

## Description

The present invention relates to a photosensitive resin composition from which a film excellent in smoothness and free from pin holes can be easily formed on a support such as a silicon wafer by spin coating or the like, and which is excellent in shelf stability and viscosity stability of varnish and high in sensitivity, and to a method for producing relief patterns using the composition.

Hitherto, polyimides which are excellent in heat resistance and are superior in electrical insulation properties and mechanical strength have been used for surface protective films and layer insulation films of semiconductor devices. However, recently a technique to impart photosensitivity to the polyimides per se has been noticed for simplification of the complicated steps for production of polyimide relief patterns.

For example, polyimide precursor compositions in which a photosensitive group is given through an ester group, and which have the structure represented by the following formula are known (Japanese Patent Kokoku No.55-41422).

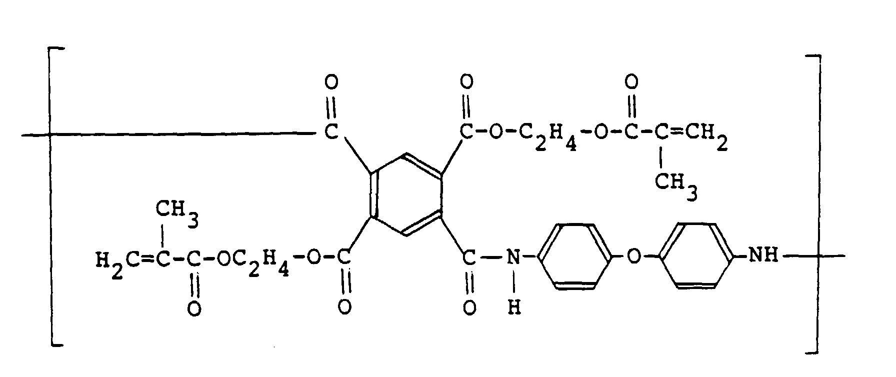

These are dissolved in suitable organic solvents, the resulting solutions are coated in the state of varnish and dried, then the coated film is irradiated with ultraviolet rays through a photo mask, developed and rinsed to obtain the desired pattern and the pattern is further heat treated to obtain a polyimide relief pattern.

When polyimides with photosensitivity given are used, not only the effect to simplify the steps of pattern formation is obtained, but also use of them is safe and hardly causes environmental pollution because it is not necessary to use highly toxic etching liquids. Therefore, it is expected that the technique to photosensitize polyimides becomes further important.

However, when such conventional photosensitizing techniques are applied, photosensitive polyimide resin compositions with a photosensitive group introduced through an ester group have the problems that they are low in viscosity stability at room temperature and that cissings or pin holes are apt to occur when they are coated on silicon wafers which are applied to semiconductors or the like. Furthermore, polyimide precursors having such ester group, when dissolved in solvents, greatly change in viscosity in the state of varnish.

Therefore, it has been proposed to add various inhibitors in order to stabilize viscosity or to use mixed solvents or various surface smoothing agents in order to improve coatability. Furthermore, it has been attempted to add phenols or N-nitrosodiarylamine compounds (Japanese Patent Kokai No.61-254605), but the effect is small and more effective viscosity stabilizers have been demanded. For obtaining a relief pattern, the polyamic acid ester is dissolved in a suitable solvent or mixed solvent, and to the solution are added photopolymerization initiator, sensitizer, copolymerizable monomer or resin, adhesive aid, inhibitor, leveling agent, etc., and the resulting composition in the state of varnish is coated and dried, then irradiated with ultraviolet rays through a photomask, and subjected to development and rinsing treatment to obtain the desired pattern. This is further heat treated to obtain a polyimide relief pattern. The development and rinsing are important for the formation of polyimide pattern. This is because these steps affect the resolution of the pattern, the dimensional accuracy of the pattern, the adhesion to wafers, etc.

Conventionally known developers are one or more of good solvents for polyamic acid esters or mixtures of the good solvents with poor solvents. As the good solvents, mention may be made of N,N-dimethylformamide, N,N-dimethylacetamide, N-methyl-2-pyrrolidone, 4-butyrolactone, dimethyl sulfoxide, etc. As the poor solvents, mention may be made of toluene, xylene, ethanol, methanol, iso-propanol, butyl acetate, water, etc.

As for the construction of the developer, there have been known to use an aliphatic or alicyclic ketone of 3-7 carbon atoms alone (Japanese Patent Kokoku No.2-2135), to use a mixture of N,N-dimethylformamide, N,N-dimethylacetamide, N-methyl-2-pyrrolidone, 4-butyrolactone, dimethyl sulfoxide, etc./methanol/diethylene glycol or its mono- or dialkyl ethers (Japanese Patent Kokai No.58-223149), or to use developers comprising 30-100% by weight of one or two or more of glycol ethers represented by the following formula:

CₓH₂ₓ₊₁-(OCH₂CH₂)_{y}-OC_{z}H_{2z+1}

(X=1-4, y=1-4, z=1-4) and 70-0% by weight of one or two or more of N,N-dimethylformamide, N,N-dimethylacetamide, N-methyl-2-pyrrolidone, 4-butyrolactone, dimethyl sulfoxide, tetrahydrofuran, toluene, xylene, ethanol, iso-propanol and butyl acetate (Japanese Patent Kokai No.4-252400).

However, when the above developers are used in formation of relief patterns of photosensitive polyamic acid ester resin composition, there has been the problem that a high resolution cannot be obtained because of the swelling of the exposed and insolubilized layer.

The present invention has overcome the problems in the conventional photosensitive polyamic acid ester resin compositions, and the present invention provides a photosensitive resin composition which shows no occurrence of cissings and pin holes in coating, can easily give a film excellent in smoothness and is high in sensitivity and excellent in shelf stability and viscosity stability, and its use for producing relief patterns.

Thus, the present invention relates to a photosensitive resin composition which comprises, as essential components,
(A) a polyamic acid ester comprising structural units represented by the following formulas (1a), (1b) and (1c): 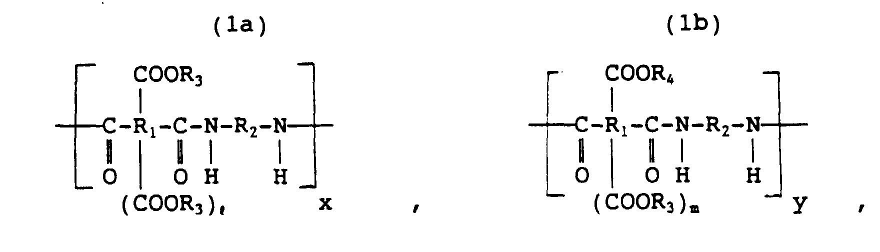 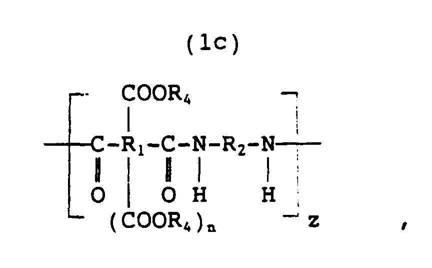 wherein
   R₁: a trivalent or tetravalent organic group,
   R₂: a divalent organic group
   R₃: 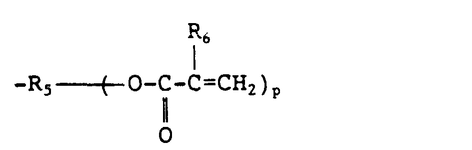
   R₄: 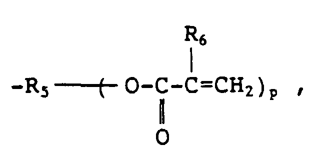 -CH₃, or C₂H₅
   R₅: a divalent to hexavalent organic group,
   R₆: H or CH₃ group,
   R₁, R₂, R₃, R₄, R₅ and R₆ are independent of one another and may be the same or different,

   ℓ, m, n: 0 or 1, p: an integer of 1-5,
   x, y, z: mol% of the structural units (1a), (1b), (1c), 0 < x, y < 100, 0 < z < 80 and x+y+z=100, and
(B) as a stabilizer propylene glycol monomethyl ether acetate.

The polyamic acid esters comprising the structural units represented by the formulas (1a), (1b) and (1c) used in the present invention have a high reactivity and the cured products thereof have good heat resistance, mechanical properties and electric properties.

In the formulas (1a), (1b) and (1c), R₁ is derived from compounds having a trivalent or tetravalent organic group, and normally aromatic tetracarboxylic acids or the derivatives thereof and aromatic tricarboxylic acids or the derivatives thereof are mainly used. Examples thereof are trimellitic anhydride, pyromellitic dianhydride, benzene-1,2,3,4-tetracarboxylic acid dianhydride, 3,3',4,4'-benzophenonetetracarboxylic acid dianhydride, 2,2',3,3'-benzophenonetetracarboxylic acid dianhydride, 2,3,3',4'-benzophenonetetracarboxylic acid dianhydride, naphthalene-2,3,6,7-tetracarboxylic acid dianhydride, naphthalene-1,2,5,6-tetracarboxylic acid dianhydride, naphthalene-1,2,4,5-tetracarboxylic acid dianhydride, naphthalene-1,4,5,8-tetracarboxylic acid dianhydride, naphthalene-1,2,6,7-tetracarboxylic acid dianhydride, 4,8-dimethyl-1,2,3,5,6,7-hexahydronaphthalene-1,2,5,6-tetracarboxylic acid dianhydride, 4,8-dimethyl-1,2,3,5,6,7-hexahydronaphthalene-2,3,6,7-tetracarboxylic acid dianhydride, 2,6-dichloronaphthalene-1,4,5,8-tetracarboxylic acid dianhydride, 2,7-dichloronaphthalene-1,4,5,8-tetracarboxylic acid dianhydride, 2,3,6,7-tetrachloronaphthalene-1,4,5,8-tetracarboxylic acid dianhydride, 1,4,5,8-tetrachloronaphthalene-2,3,6,7-tetracarboxylic acid dianhydride, 3,3',4,4'-diphenyltetracarboxylic acid dianhydride, 2,2',3,3'-diphenyltetracarboxylic acid dianhydride, 2,3,3',4'-diphenyltetracarboxylic acid dianhydride, 3,3",4,4"-p-terphenyltetracarboxylic acid dianhydride, 2,2",3,3"-p-terphenyltetracarboxylic acid dianhydride, 2,3,3",4"-p-terphenyltetracarboxylic acid dianhydride, 2,2-bis(2,3-dicarboxyphenyl)-propane dianhydride, 2,2-bis(3,4-dicarboxyphenyl)-propane dianhydride, bis(2,3-dicarboxyphenyl) ether dianhydride, bis(3,4-dicarboxyphenyl) ether dianhydride, bis(2,3-dicarboxyphenyl)methane dianhydride, bis(3,4-dicarboxyphenyl)methane dianhydride, bis(2,3-dicarboxyphenyl)sulfone dianhydride, bis(3,4-dicarboxyphenyl)sulfone dianhydride, 1,1-bis(2,3-dicarboxyphenyl)ethane dianhydride, 1,1-bis(3,4-dicarboxyphenyl)ethane dianhydride, perylene-2,3,8,9-tetracarboxylic acid dianhydride, perylene-3,4,9,10-tetracarboxylic acid dianhydride, perylene-4,5,10,11-tetracarboxylic acid dianhydride, perylene-5,6,11,12-tetracarboxylic acid dianhydride, phenanthrene-1,2,7,8-tetracarboxylic acid dianhydride, phenanthrene-1,2,6,7-tetracarboxylic acid dianhydride, phenanthrene-1,2,9,10-tetracarboxylic acid dianhydride, cyclopentane-1,2,3,4-tetracarboxylic acid dianhydride, pyrazine-2,3,5,6-tetracarboxylic acid dianhydride, pyrrolidine-2,3,4,5-tetracarboxylic acid dianhydride, and thiophene-2,3,4,5-tetracarboxylic acid dianhydride. These are not limitative. These may be used each alone or in admixture of two or more.

R₂ in the formulas (1a), (1b) and (1c) is a divalent organic group, and aromatic diamines and/or derivatives thereof are normally used for introduction of the group. As examples thereof, mention may be made of m-phenylene-diamine, 1-isopropyl-2,4-phenylene-diamine, p-phenylene-diamine, 4,4'-diamino-diphenylpropane, 3,3'-diamino-diphenylpropane, 4,4'-diamino-diphenylethane, 3,3'-diamino-diphenylethane, 4,4'-diamino-diphenylmethane, 3,3'-diamino-diphenylmethane, 4,4'-diamino-diphenyl sulfide, 3,3'-diamino-diphenyl sulfide, 4,4'-diamino-diphenyl sulfone, 3,3'-diamino-diphenyl sulfone, 4,4'-diamino-diphenyl ether, 3,3'-diamino-diphenyl ether, benzidine, 3,3'-diamino-biphenyl, 3,3'-dimethyl-4,4'-diamino-biphenyl, 3,3'-dimethoxy-benzidine, 4,4''-diamino-p-terphenyl, 3,3''-diamino-p-terphenyl, bis(p-amino-cyclohexyl)methane, bis(p-β-amino-t-butylphenyl) ether, bis(p-β-methyl-δ-aminopentyl)benzene, p-bis(2-methyl-4-amino-pentyl)benzene, p-bis(1,1-dimethyl-5-amino-pentyl)benzene, 1,5-diamino-naphthalene, 2,6-diamino-naphthalene, 2,4-bis(β-amino-t-butyl)toluene, 2,4-diamino-toluene, m-xylene-2,5-diamine, p-xylene-2,5-diamine, m-xylylene-diamine, p-xylylene-diamine, 2,6-diamino-pyridine, 2,5-diamino-pyridine, 2,5-diamino-1,3,4-oxadiazole, 1,4-diamino-cyclohexane, piperazine, methylene-diamine, ethylene-diamine, propylene-diamine, 2,2-dimethyl-propylene-diamine, tetramethylene-diamine, pentamethylene-diamine, hexamethylene-diamine, 2,5-dimethyl-hexamethylene-diamine, 3-methoxy-hexamethylene-diamine, heptamethylene-diamine, 2,5-dimethyl-heptamethylene-diamine, 3-methyl-heptamethylene-diamine, 4,4-dimethyl-heptamethylene-diamine, octamethylene-diamine, nonamethylene-diamine, 5-methyl-nonamethylene-diamine, 2,5-dimethyl-nonamethylene-diamine, decamethylene-diamine, 1,10-diamino-1,10-dimethyl-decane, 2,11-diamino-dodecane, 1,12-diamino-octadecane, 2,12-diamino-octadecane, 2,17-diamino-eicosane, diamino-siloxane, 2,6-diamino-4-carboxylic benzene, 3,3'-diamino-4,4'-dicarboxylic benzidine, and 1,3-bis(3-aminopropyl)tetramethyldisiloxane. These are not limitative. These may be used each alone or in admixture of two or more.

In the formulas (1a), (1b) and (1c), R₃ is a photosensitive group having one to five acryl or methacryl groups and R₄ is a photosensitive group having one to five acryl or methacryl groups or methyl group or ethyl group. When the number of acryl (methacryl) groups in R₃ or R₄ is 0, no crosslinked structure is obtained and this is not preferred. When it is 6 or more, not only the industrial production is difficult, but also the molecular weight is great and compatibility deteriorates. Examples of the compounds for introduction of R₃ or R₄ are pentaerythritol triacrylate, pentaerythritol trimethacrylate, pentaerythritol acrylate dimethacrylate, pentaerythritol diacrylate methacrylate, dipentaerythritol pentacrylate, dipentaerythritol pentamethacrylate, glycerol diacrylate, glycerol dimethacrylate, glycerol acrylate methacrylate, trimethylolpropane diacrylate, 1,3-diacryloylethyl-5-hydroxyethyl isocyanurate, 1,3-dimethylacrylate-5-hydroxyethyl isocyanurate, ethylene glycol-modifed pentaerythritol triacrylate, propylene glycol-modifed pentaerythritol triacrylate, trimethylolpropane diacrylate, trimethylolpropane dimethacrylate, 2-hydroxyethyl methacrylate, 2-hydroxyethyl acrylate, glycidyl methacrylate, glycidyl acrylate, 2-hydroxypropyl methacrylate, 2-hydroxypropyl acrylate, polyethylene glycol-modified methacrylate, polyethylene glycol-modified acrylate, polypropylene glycol-modified acrylate and polypropylene glycol-modifed methacrylate. These are not limitative. These may be used each alone or in admixture of two or more. The methyl group or ethyl group of R₄ is normally derived from methanol or ethanol.

R₅ is a di- to hexavalent organic group obtained by excluding hydroxyl group and acryloyloxy group or methacryloyloxy group from the above-mentioned compounds used for introducing R₃ or R₄, and preferred are di- to trivalent aliphatic groups.

In the polyamic acid esters comprising the structural units represented by the formulas (1a), (1b) and (1c) used in the present invention, the proportion of the structural unit (1a) where R₃ is introduced into carboxyl groups is x, the proportion of the structural unit (1b) where R₃ is introduced into a part of carboxyl groups and R₄ is introduced into the remainder carboxyl groups is y, and the proportion of the structural unit (1c) where carboxyl groups are substituted with R4 is z, and the three structural units are present together. They satisfy 0 < x, y < 100, 0 < z < 80 and x+y+z=100, and x, y and z show mol percentages of the respective structural units. In the case of R₄ being -CH₃ or -C₂H₅, when z is 80 or more, amount of the photosensitive group is small and sensitivity is low and practicality is low.

The polyamic acid esters in the present invention are usually synthesized in the following manner. First, a compound having an alcohol group for introducing polyfunctional photosensitive groups R₃ and R₄ is dissolved in a solvent and is allowed to react with an excess acid anhydride or a derivative thereof. Thereafter, the remaining carboxyl groups and acid anhydride groups are allowed to react with a diamine, whereby the esters are synthesized.

The propylene glycol monomethyl ether acetate has hitherto been used as a solvent for epoxy resins, urethane resins, etc., but has never been investigated for use as a solvent or stabilizer for polyimide resins.

In the present invention, the propylene glycol monomethyl ether acetate has a proper solvency for the polyamic acid ester and the resulting polyamic acid ester solution is superior in shelf stability such as viscosity. Furthermore, the resulting photosensitive resin composition is superior in coatability and hardly produces cissings or pin holes when coated on a silicon wafer and is excellent in smoothness.

As other solvents or stabilizers used, mention may be made of N,N-dimethylformamide, N,N-dimethylacetamide, N,N-diethylformamide, N,N-diethylacetamide, N,N-dimethylmethoxyacetamide, dimethyl sulfoxide, hexamethylphosphoamide, N-methyl-2-pyrrolidone, pyridine, dimethyl sulfone, tetramethyl sulfone, dimethyltetramethylene sulfone, benzonitrile, butyrolacton, xylene, toluene, cyclohexanone, glycol ether and lactate esters. These are not limitative.

Amount of the propylene glycol monomethyl ether acetate is preferably 50-500 parts by weight for 100 parts by weight of the polyamic acid ester and this is not limitative. If the amount of the propylene glycol monomethyl ether acetate is less than 50 parts by weight, no uniform solution can be obtained or when used together with other solvents, a uniform solution can be obtained, but coatability decreases and this is not preferred.

If it is more than 500 parts by weight, a uniform solution can be obtained, but since the amount of the solvent is too much for the resin solid content, the concentration decreases and apparent viscosity of the solution decreases, which causes deterioration of coatability to result in cissings.

In the present invention, sensitizers may be added in order to improve lithographic characteristics such as sensitivity and resolution. Examples of the sensitizers are shown below. These are not limitative.

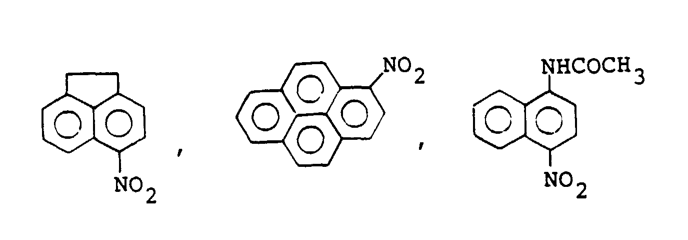

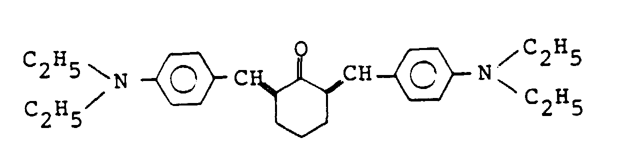

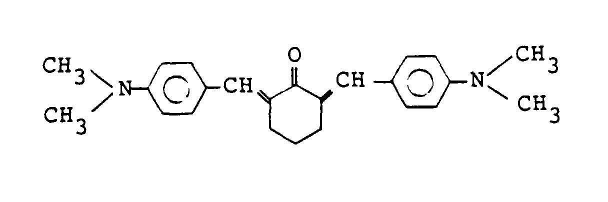

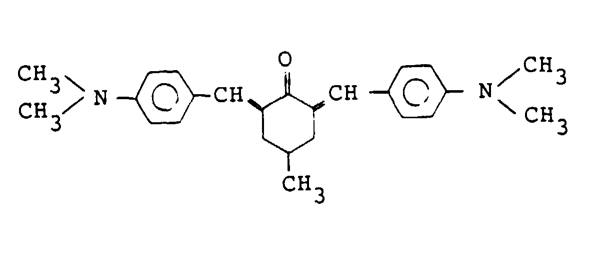

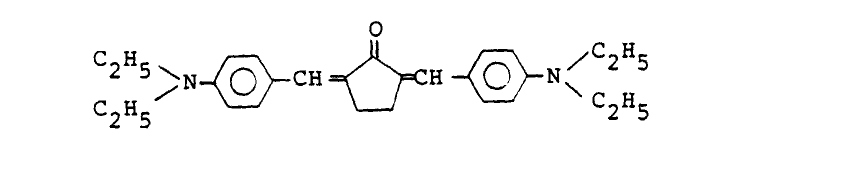

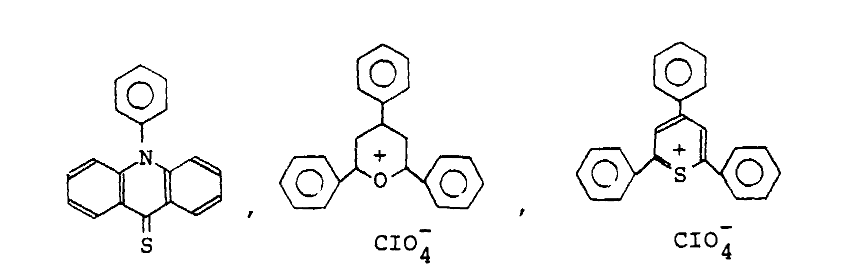

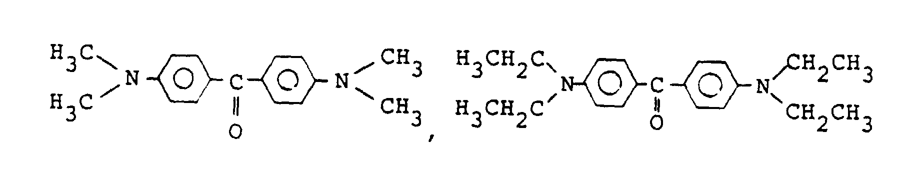

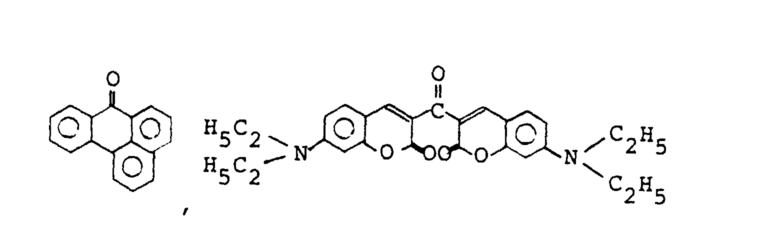

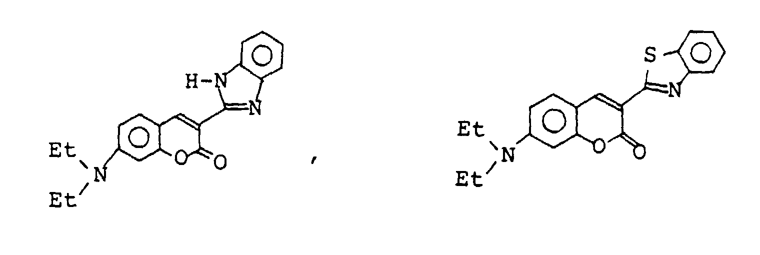

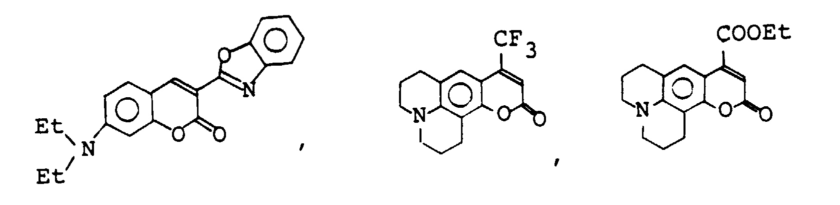

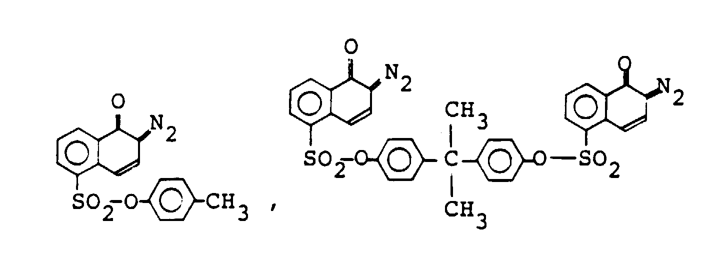

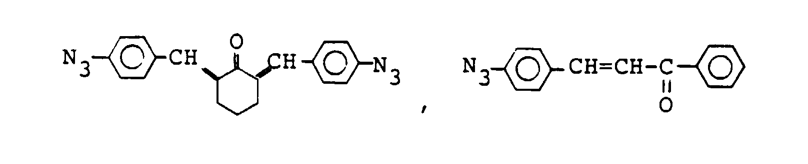

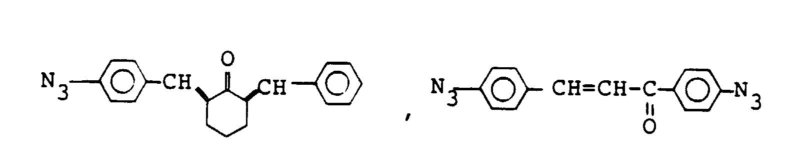

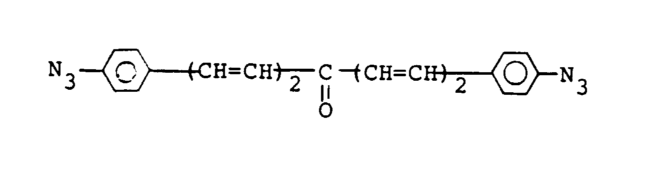

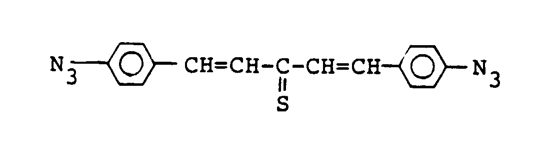

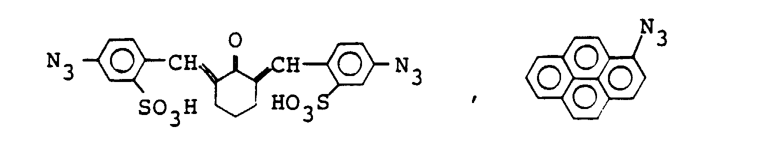

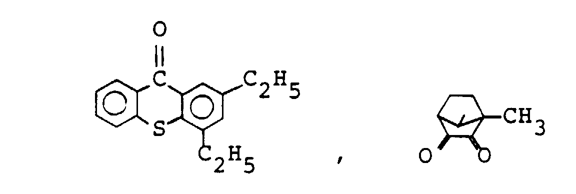

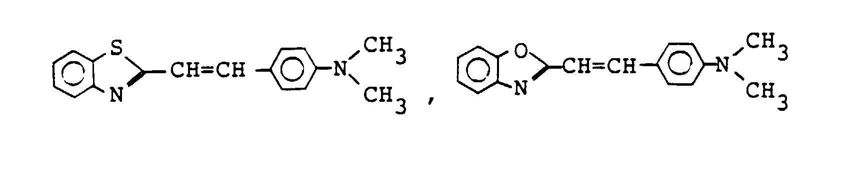

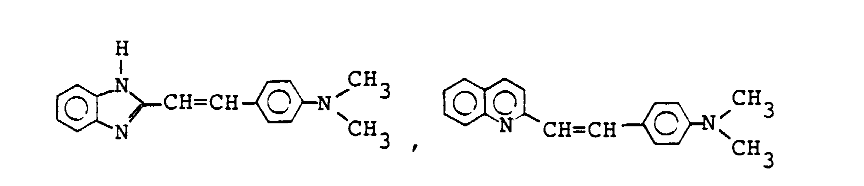

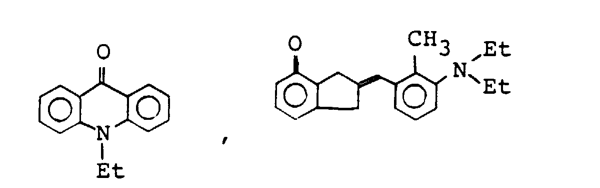

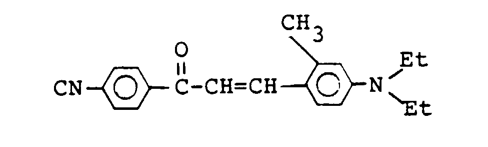

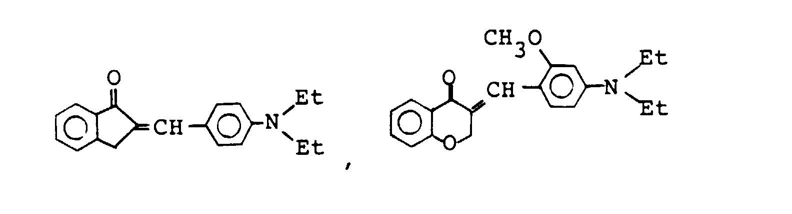

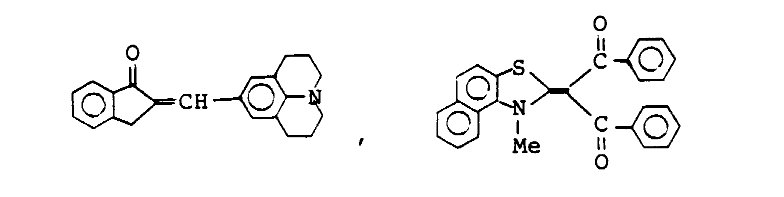

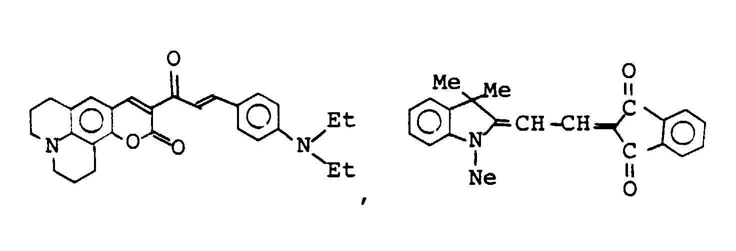

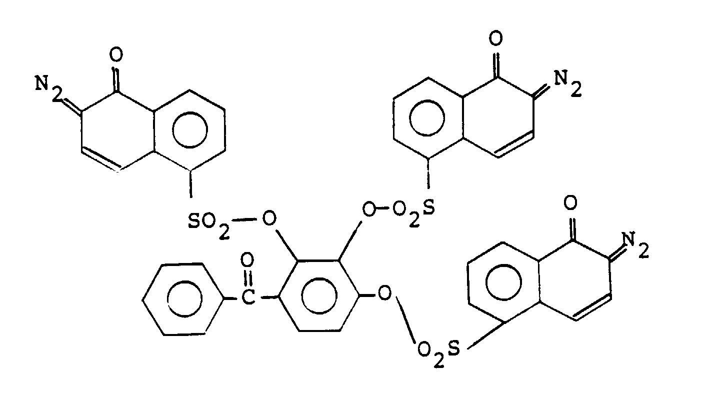

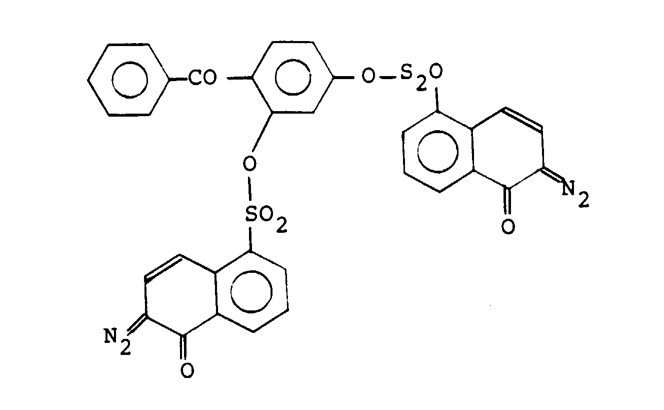

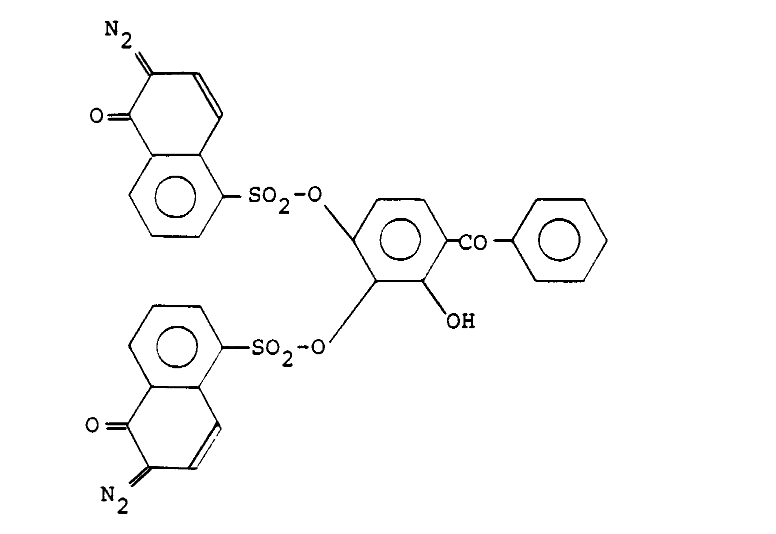

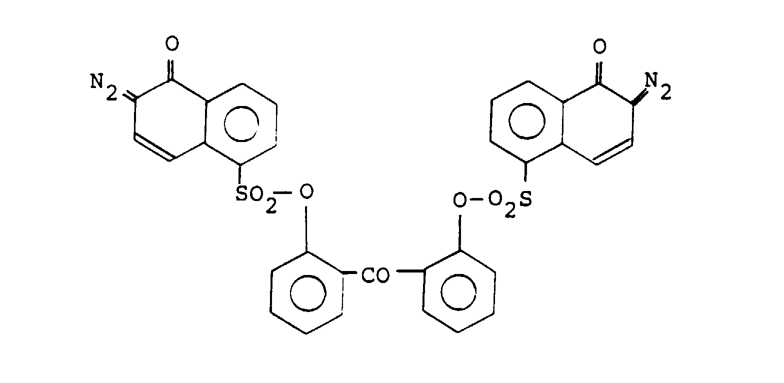

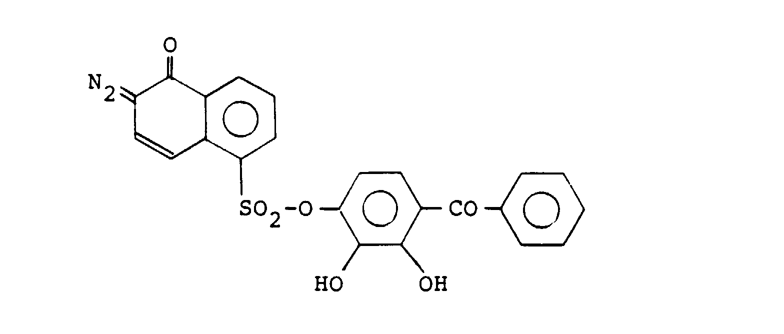

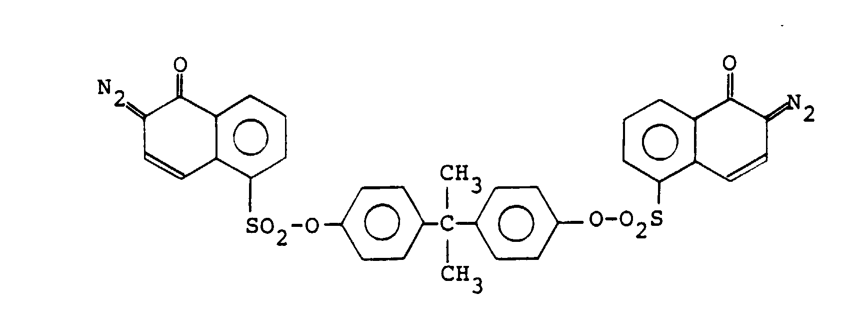

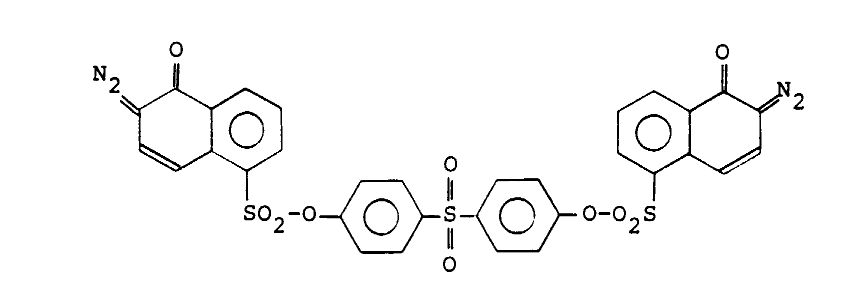

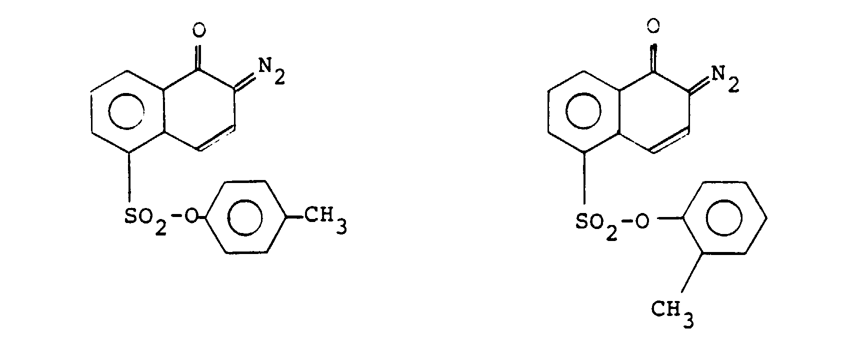

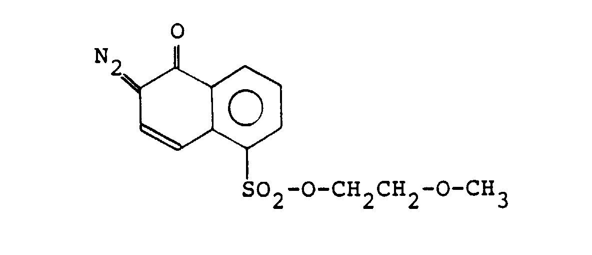

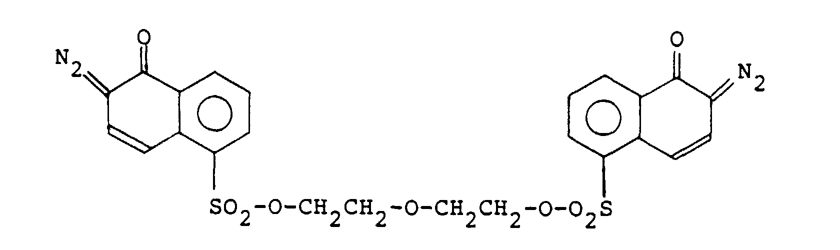

As photopolymerization initiators in the present invention, there can be used the following compounds which are generally used for UV-curing resins. These are not limitative. These may be used each alone or in admixture of two or more.

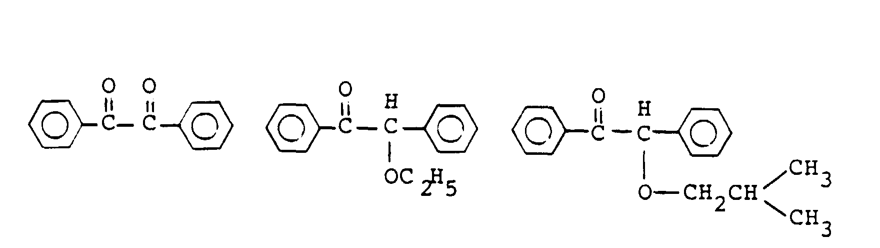

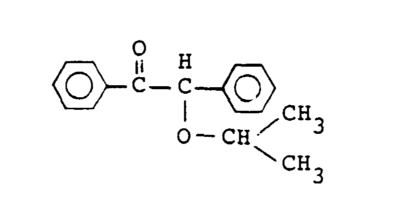

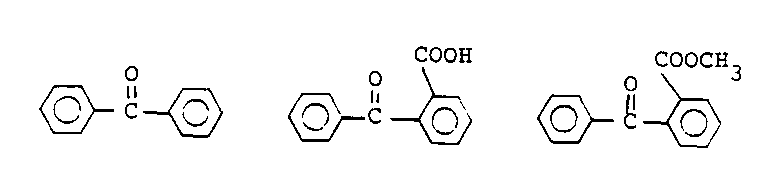

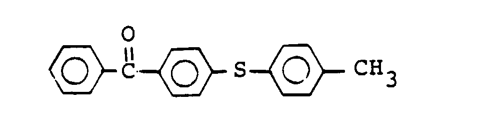

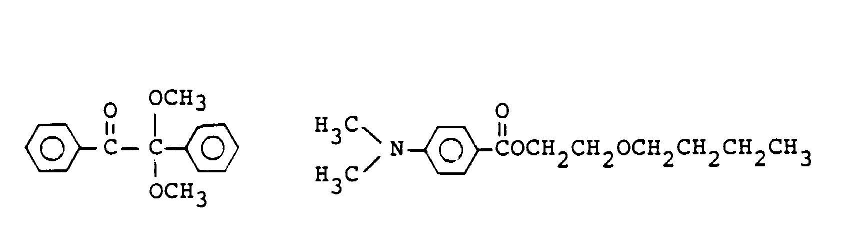

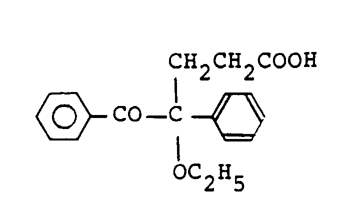

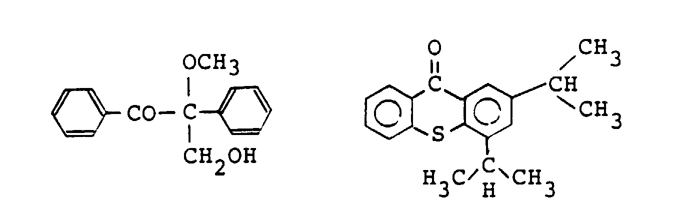

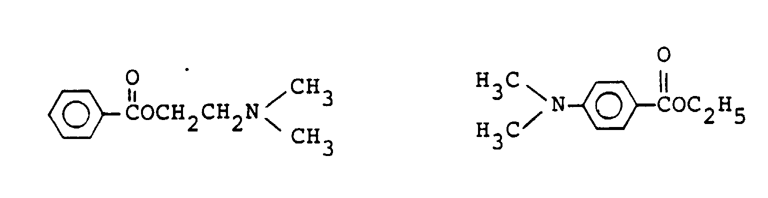

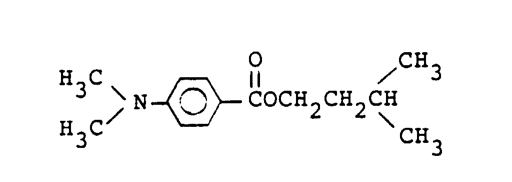

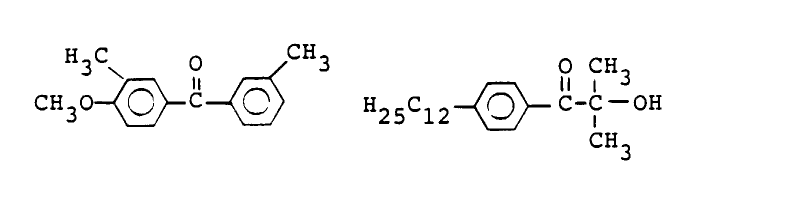

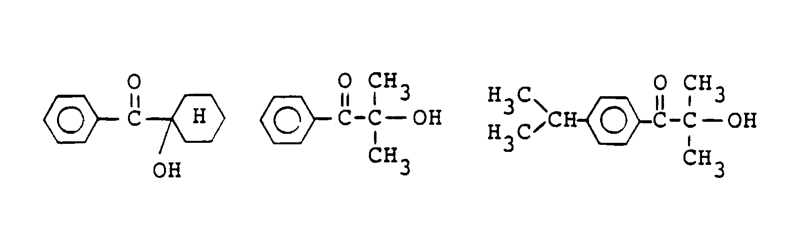

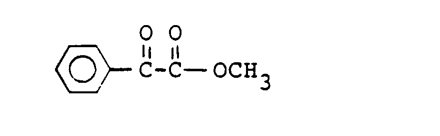

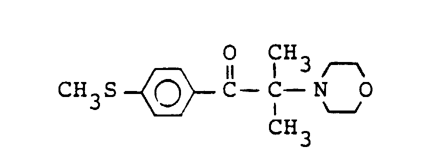

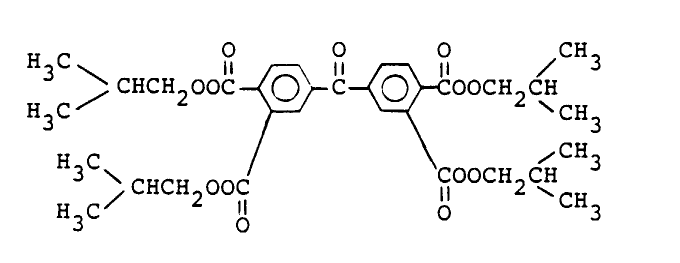

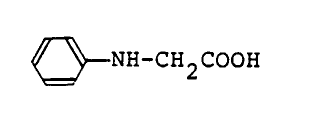

The sensitizers also act as a photopolymerization initiator. Amount of the sensitizer or photopolymerization initiator is preferably 0.1-10 parts by weight for 100 parts by weight of the polyamic acid ester. If it is less than 0.1 part by weight, the amount is too small and the effect to improve the sensitivity can be obtained with difficulty. If it is more than 10 parts by weight, the strength of cured film decreases.

As the shelf stability improvers, mention may be made of 1-phenyl-5-mercapto-1H-tetrazole, 2-mercaptobenzothiazole, 2-mercaptobenzimidazole, 2-mercaptobenzoxazole, pentaerythritol tetrakis-(thioglycolate), thioglycollic acid, ammonium thioglycolate, butyl thioglycolate, octyl thioglycolate, methoxybutyl thioglycolate, trimethylolpropane tris-(thioglycolate), ethylene glycol dithioglycolate, β-mercaptopropionic acid, octyl β-mercaptopropionate, trimethylolpropane tris-(β-thiopropionate), pentaerythritol tetrakis-(β-thiopropionate), 1,4-butanediol dithiopropionate, thiosalicylic acid, furfuryl mercaptan, benzyl mercaptan, α-mercaptopropionic acid, p-hydroxythiophenol, p-methylthiophenol, and thiophenol. These are not limitative.

For the purpose of further improvement of sensitivity, a photopolymerizable monomer having a carbon-carbon double bond can be added in the present invention. As examples of the monomer, mention may be made of trimethylolpropane triacrylate, pentaerythritol triacrylate, dipentaerythritol hexaacrylate, 1,6-hexanediol diacrylate, neopentyl glycol diacrylate, ethylene glycol diacrylate, tetraethylene glycol diacrylate, polyethylene glycol diacrylate, 2-hydroxyethyl acrylate, isobornyl acrylate, N-methylolacrylamide, N,N-dimethylacrylamide and methacrylates and methacrylamides corresponding to these acrylates and acrylamides.

The photosensitive resin compositions of the present invention may contain adhesive aids, inhibitors, levelling agents and various fillers.

The method for producing a relief pattern using the photosensitive resin composition of the present invention comprises the following steps. First, the composition is coated on a suitable support such as silicon wafer, ceramic, aluminum substrate or the like. The coating is carried out by spin coating by a spinner, spray coating by a spray coater, dip coating, print coating, roll coating or the like. Then, the coated film is dried by pre-baking at a low temperature of 60-120°C and is irradiated with actinic rays in the form of a desired pattern. As the actinic rays, X-rays, electron rays, ultraviolet rays, visible rays and the like can be used, and preferred are those which have a wavelength of 200-500 nm. Next, the unirradiated portion is dissolved with a developer to remove it, thereby to obtain a relief pattern.

The developer used in the present invention comprises (A) 10-40% by weight of iso-propanol and (B) 90-60% by weight of one or two or more selected from N,N-dimethylformamide, N,N-dimethylacetamide, N-methyl-2-pyrrolidone, 4-butyrolactone, dimethyl sulfoxide and tetrahydrofuran. The combination per se of the solvents (A) and (B) is known, but swelling of the exposed portion can be highly inhibited and a pattern of very high resolution can be obtained by effecting the development with a mixed solvent within the range mentioned above. If content of the (B) is more than 90% by weight in total, the solvency is too high and the exposed portion is also swollen, and if it is less than 60% by weight, dissolution of the unexposed portion is insufficient to cause whitening.

Developing method includes, for example, spray, paddle, dip and ultrasonic developments. Next, the relief pattern formed by the development is rinsed. As the rinsing liquid, there may be used toluene, xylene, ethanol, methanol, iso-propanol, butyl acetate, water and the like. Then, the relief pattern is heat-treated to form imide ring to obtain a final relief pattern high in heat resistance.

The photosensitive resin composition of the present invention is useful not only for semiconductors, but also for layer insulation films of multilayer circuit boards, cover coat and solder resist film of flexible copper-clad boards, liquid crystal alignment films, etc.

### Best Mode for Carrying Out the Invention

The present invention will be explained more specifically by the following examples.

### Example 1

65.5 g (0.30 mol) of pyromellitic acid dianhydride and 225.5 g (0.70 mol) of 3,3',4,4'-benzophenonetetracarboxylic acid dianhydride were reacted with 456 g (2.00 mols) of 2-hydroxy-1,3-dimethacryloxypropane to esterify the carboxyl group and thereafter, the reaction product was reacted with 170.2 g (0.85 mol) of 4,4'-diaminodiphenyl ether using dicyclohexylcarbodimide as a condensation agent to obtain a polyamic acid ester copolymer. Dicyclohexylurea was filtrated off, followed by reprecipitation with ethanol and the solid was filtrated and dried under reduced pressure. 100 parts by weight of this polyamic acid ester and 6 parts by weight of N-phenylglycine, 1 part by weight of 1-phenyl-5-mercapto-1H-tetrazole, 1 part by weight of 2-(p-dimethylaminostyryl)benzothiazole and 10 parts by weight of tetraethylene glycol dimethacrylate were dissolved in 200 parts by weight of propylene glycol monomethyl ether acetate to obtain a photosensitive resin composition.

The rate of change in viscosity of the resulting photosensitive resin composition after left to stand at 23°C for 1 week was 3.5% and was stable.

The resulting solution was coated on a silicon wafer of 5 inches by a fully-automatic coater (DSIPN-636 manufactured by Dainippon Screen Mfg., Co., Ltd.) so that the resultant film had a thickness of 5 µm, and was dried at 100°C for 3 minutes by a hot plate.

Neither pin holes nor peeling occurred in the resulting film. Scattering of thickness on the wafer surface was measured at 30 points by an interference film thickness gauge. The average thickness was 3.65 µm and σₙ₋₁ was 0.004 µm which indicated the excellence of the film.

### Example 2

Reaction was effected in the same manner as in Example 1 except that amount of 2-hydroxy-1,3-dimethacryloxypropane was reduced to 228 g and 32 g (1.00 mol) of methanol was added, thereby to obtain a photosensitive resin composition. Evaluation was conducted in the same manner as in Example 1. The rate of change in viscosity was 1.2% and stable. Neither pin holes nor peeling was seen. The average film thickness was 3.26 µm and σₙ₋₁ was 0.004 µm which indicated the excellence of the film.

### Example 3

Reaction was effected in the same manner as in Example 1 except that 240 g (2.00 mols) of 2-hydroxyethyl methacrylate was used in place of 2-hydroxy-1,3-dimethacryloxypropane, thereby to obtain a photosensitive resin composition. Evaluation was conducted in the same manner as in Example 1. The rate of change in viscosity was 4.9% and stable. Neither pin holes nor peeling was seen. The average film thickness was 4.23 µm and σₙ₋₁ was 0.012 µm which indicated the excellence of the film.

### Example 4

A photosensitive resin composition was obtained by omitting N-phenylglycine, 1-phenyl-5-mercapto-1H-tetrazole, 2-(p-dimethylaminostyryl)benzothiazole and tetraethylene glycol dimethacrylate in Example 1. Evaluation was conducted in the same manner as in Example 1. The rate of change in viscosity was 5.3% and stable. Neither pin holes nor peeling was seen. The average film thickness was 2.84 µm and σₙ₋₁ was 0.014 µm which indicated the excellence of the film.

### Example 5

To the photosensitive resin composition obtained in Example 1 was further added 3 parts by weight of trimethoxysilylpropyl methacrylate, and the resulting photosensitive resin composition was evaluated in the same manner as in Example 1. The rate of change in viscosity was 2.1% and stable. Neither pin holes nor peeling was seen. The average film thickness was 3.88 µm and σₙ₋₁ was 0.009 µm which indicated the excellence of the film.

### Example 6

A photosensitive resin composition was obtained in the same manner as in Example 1 except that 100 parts by weight of N-methyl-2-pyrrolidone was used in place of 100 parts by weight among 200 parts by weight of propylene glycol monomethyl ether acetate and was evaluated in the same manner as in Example 1. The rate of change in viscosity was 1.4% and stable. Neither pin holes nor peeling was seen. The average film thickness was 3.21 µm and σₙ₋₁ was 0.008 µm which indicated the excellence of the film.

### Comparative Example 1

A photosensitive resin composition was obtained in the same manner as in Example 1 except that N-methyl-2-pyrrolidone was used in place of propylene glycol monomethyl ether acetate and was evaluated in the same manner as in Example 1. The rate of change in viscosity was 4.7% and stable.

However, cissings occurred in the portion from the peripheral portion to the center portion of the wafer. The thickness of the resulting film was 3.96 µm and σₙ₋₁ was 1.14 µm, which meant a great scattering.

### Comparative Example 2

A photosensitive resin composition was obtained in the same manner as in Example 1 except that propylene glycol monomethyl ether was used in place of propylene glycol monomethyl ether acetate and was similarly evaluated. Neither pin holes nor cissings were seen. The thickness of the resulting film was 3.55 µm and σₙ₋₁ was 0.009 µm which indicated the excellence of the film, but the rate of change in viscosity was 48%, that is, the viscosity increased much.

### Comparative Example 3

A photosensitive resin composition was obtained in the same manner as in Example 1 except that propylene glycol acetate was used in place of propylene glycol monomethyl ether acetate and was similarly evaluated. Neither pin holes nor cissings were seen. The thickness of the resulting film was 3.81 µm and σₙ₋₁ was 0.012 µm which indicated the excellence of the film, but the rate of change in viscosity was 148%, that is, the viscosity increased much.

### Industrial Applicability

Using the photosensitive resin composition of the present invention, a film excellent in smoothness and free from pin holes can be easily formed on a support such as silicon wafer. The composition is excellent in shelf stability and viscosity stability and has a high sensitivity. Furthermore, a relief pattern of high resolution can be formed using the composition of the present invention in the fields of multilayer circuit boards, semiconductor devices and microelectronics devices.

## Claims

1. A photosensitive resin composition which comprises, as essential components,
(A) a polyamic acid ester comprising the structural units represented by the following formulas (1a), (1b) and (1c): 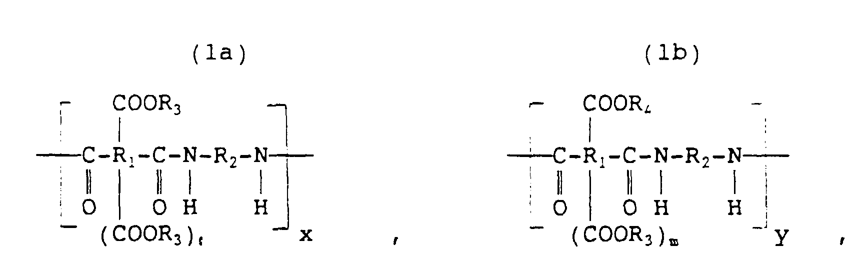 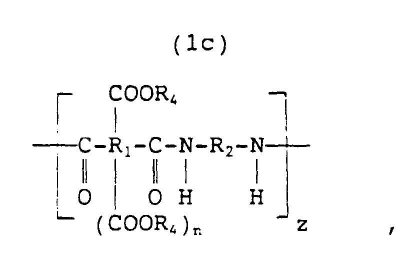 wherein
R₁: a trivalent or tetravalent organic group,
R₂: a divalent organic group
R₃: 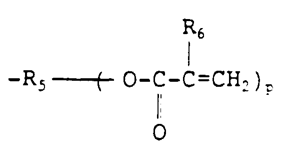
R₄: 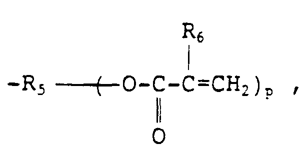 -CH₃, or C₂H₅
R₅: a divalent to hexavalent organic group,
R₆: H or CH₃ group,
R₁, R₂, R₃, R₄, R₅ and R₆ are independent of one another and may be the same or different,
ℓ, m, n: 0 or 1,
p: an integer of 1-5,
x, y, z: mol% of the structural units (1a), (1b), (1c), 0 < x, y < 100, 0 < z < 80 and x+y+z=100, and
(B) as a stabilizer propylene glycol monomethyl ether acetate.

2. A composition according to claim 1 wherein the trivalent or tetravalent organic group R₁ in the formulas (1a), (1b) and (1c) is derived from an aromatic tetracarboxylic acid or a derivative thereof or an aromatic tricarboxylic acid or a derivative thereof.

3. A composition according to claim 1 wherein the divalent organic group R₂ in the formulas (1a), (1b) and (1c) is derived from an aromatic diamine or a derivative thereof.

4. A composition according to claim 1 wherein the amount of the stabilizer is 50-500 parts by weight based on 100 parts by weight of the polyamic acid ester.

5. A composition according to claim 1 which additionally contains a sensitizer.

6. A composition according to claim 1 which additionally contains a photopolymerization initiator.

7. A composition according to claim 1 wherein R₅ is a divalent or trivalent aliphatic group.

8. A composition according to claim 1 which additionally contains a shelf stability improver.

9. The use of the photosensitive resin composition according to any one of claims 1 to 8 for preparing relief patterns.

## Patentansprüche

1. Eine photoempfindliche Harzzusammensetzung, umfassend als wesentliche Komponenten
(A) einen Polyamidsäureester, umfassend die Struktureinheiten der nachstehenden allgemeinen Formeln (1a), (1b), und (1c): 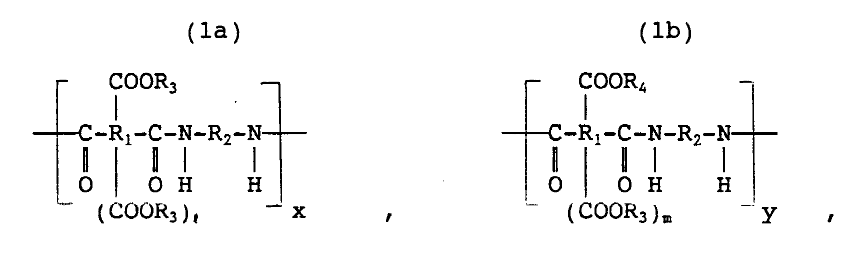 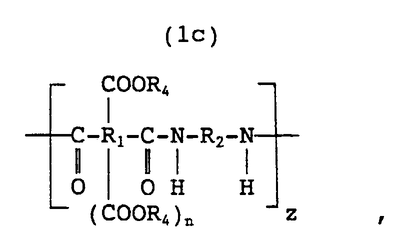 wobei
der Rest R₁ ein dreiwertiger oder vierwertiger organischer Rest ist,
der Rest R₂ ein zweiwertiger organischer Rest ist,
der Rest R₃ 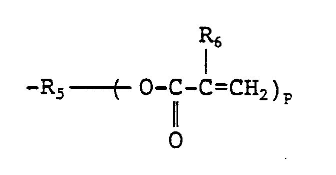 ist,
der Rest R₄ 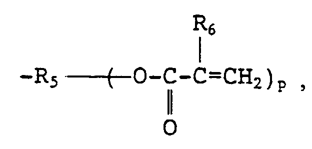 -CH₃ oder C₂H₅ ist,
der Rest R₅ ein zweiwertiger bis sechswertiger organischer Rest ist,
der Rest R₆ ein Wasserstoffatom oder die CH₃-Gruppe ist,
die Reste R₁, R₂, R₃, R₄, R₅ und R₆ voneinander unabhängig sind und gleich oder verschieden sein können,
l, m, n gleich 0 oder 1 sind,
p eine ganze Zahl von 1 bis 5 ist,
x, y, z Mol-% der Struktureinheiten (1a), (1b), (1c) sind, 0 < x, y <100, 0 < z < 80 ist und x+y+z=100 ist, und
(B) als Stabilisator Propylenglykolmonomethyletheracetat.

2. Zusammensetzung nach Anspruch 1, wobei der dreiwertige oder vierwertige organische Rest R₁ in den allgemeinen Formeln (1a), (1b) und (1c) abgeleitet ist von einer aromatischen Tetracarbonsäure oder einem Derivat davon oder einer aromatischen Tricarbonsäure oder einem Derivat davon.

3. Zusammensetzung nach Anspruch 1, wobei der zweiwertige organische Rest R₂ in den allgemeinen Formeln (1a), (1b) und (1c) abgeleitet ist von einem aromatischen Diamin oder einem Derivat davon.

4. Zusammensetzung nach Anspruch 1, wobei die Menge des Stabilisators 50 bis 500 Gewichtsteile beträgt, bezogen auf 100 Gewichtsteile des Polyamidsäureesters.

5. Zusammensetzung nach Anspruch 1, die zusätzlich ein Sensibilisierungsmittel enthält.

6. Zusammensetzung nach Anspruch 1, die zusätzlich einen Photopolymerisationsinitiator enthält.

7. Zusammensetzung nach Anspruch 1, wobei der Rest R₅ ein zweiwertiger oder dreiwertiger aliphatischer Rest ist.

8. Zusammensetzung nach Anspruch 1, die zusätzlich einen Lagerstabilitätsverbesserer enthält.

9. Verwendung der photoempfindlichen Harzzusammensetzung nach einem der Ansprüche 1 bis 8 zur Herstellung von Reliefmustern.

## Revendications

1. Composition de résine photosensible comprenant, en tant qu'ingrédients essentiels :
(A) un ester d'acide polyamique comprenant les motifs récurrents représentés par les formules suivantes (1a), (1b) et (1c) : 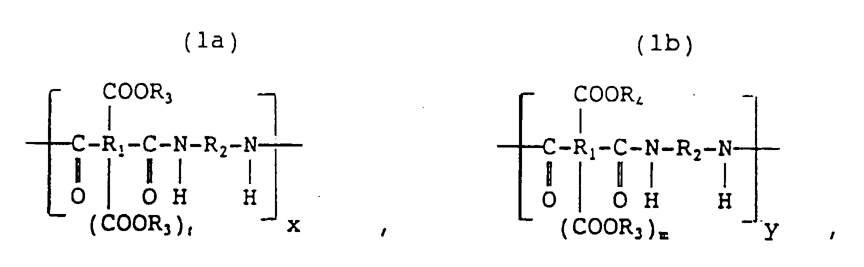 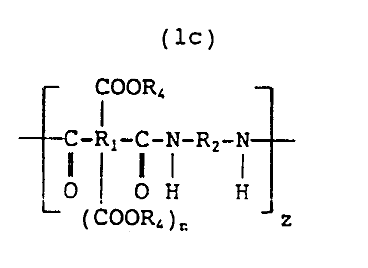 dans lesquelles :
R₁ représente un groupe organique trivalent ou tétravalent,
R₂ représente un groupe organique divalent,
R₃ représente 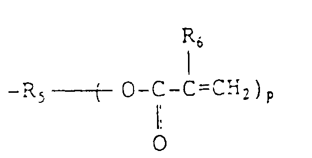
R₄ représente 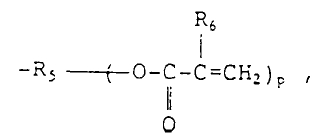 -CH₃, ou C₂H₅
R₅ représente un groupe organique divalent à hexavalent,
R6 représente H ou CH₃,
R₁, R₂, R₃, R₄, R₅ et R₆ sont indépendants les uns des autres et peuvent être identiques ou différents,
*ℓ,* m, n représentent 0 ou 1,
p est un entier de 1 à 5,
x, y, z représentent le pourcentage molaire des motifs récurrents (1a), (1b), (1c), 0 < x, y < 100, 0 < z < 80 et x+y+z = 100,
et
(B) en tant que stabilisant, l'éther monométhylique de l'acétate de propylèneglycol.

2. Composition selon la revendication 1 dans laquelle le groupe organique trivalent ou tétravalent R₁ dans les formules (1a), (1b) et (1c) dérive d'un acide aromatique tétracarboxylique ou d'un de ses dérivés ou bien d'un acide aromatique tricarboxylique ou d'un de ses dérivés.

3. Composition selon la revendication 1 dans laquelle le groupe organique divalent R₂ dans les formules (1a), (1b) et (1c) dérive d'une diamine aromatique ou d'un de ses dérivés.

4. Composition selon la revendication 1 dans laquelle la quantité de stabilisant varie de 50 à 500 parties en poids pour 100 parties en poids de l'ester de l'acide polyamique.

5. Composition selon la revendication 1 contenant en outre un sensibilisateur.

6. Composition selon la revendication 1 contenant en outre un initiateur de photopolymérisation.

7. Composition selon la revendication 1 dans laquelle R₅ est un groupe aliphatique divalent ou trivalent.

8. Composition selon la revendication 1 contenant en outre un agent améliorant la stabilité au stockage.

9. Utilisation d'une composition de résine photosensible selon l'une quelconque des revendications 1 à 8 pour la préparation de motifs en relief.
